# EUROPEAN PATENT SPECIFICATION

(11) **EP 1 237 282 B1**
(45) Date of publication and mention of the grant of the patent: **08.10.2003**
(21) Application number: 02250671.1
(22) Date of filing: 31.01.2002
(51) Int. Cl.: H03K 21/40

(54) **Circuit for the detection of clock signal period abnormalities**
Schaltung zur Detektion von Störungen der Periodendauer in einem Taktsignal
Circuit pour la détection des pertubations des périodes dans un signal d'horloge

(30) Priority: 23.02.2001 JP 2001048354
(43) Date of publication of application: 04.09.2002
(73) Proprietor: NEC Electronics Corporation, Kawasaki, Kanagawa 211-8668 (JP)
(72) Inventor: Senba, Hisanori, c/o NEC Micro Systems, Ltd., Kawasaki-shi, Kanagawa (JP)
(74) Representative: W.P. THOMPSON & CO.

(56) References cited:
- SU-A- 1 798 919
- US-A- 5 619 155
- PATENT ABSTRACTS OF JAPAN vol. 1998, no. 07, 31 March 1998 (1998-03-31) & JP 09 016281 A (UNITED MICROELECTRON CORP), 17 January 1997 (1997-01-17)
- "DEVICE FOR OVERCLOCK DETECTION AND MARKING" RESEARCH DISCLOSURE, KENNETH MASON PUBLICATIONS, HAMPSHIRE, GB, no. 432, April 2000 (2000-04), page 692 XP000968874 ISSN: 0374-4353
- DATABASE WPI Section EI, Week 199840 Derwent Publications Ltd., London, GB; Class U21, AN 1998-465910 XP002198097 & RU 2 105 411 C (NUCLEAR CENTRE EXPER PHYS RES INST), 20 February 1998 (1998-02-20)
- DATABASE WPI Section EI, Week 198202 Derwent Publications Ltd., London, GB; Class T01, AN 1982-A4275E XP002198098 & SU 817 717 A (DZHAGAROV YU A), 30 March 1981 (1981-03-30)

## Description

The present invention relates to a monitoring circuit for determining whether the period of a clock signal has become shorter than a predetermined permissible range.

Processors that operate in synchronization with a clock signal generated by a clock generating circuit and that execute various types of processing are currently implemented, for example in the form of MPUs (Micro Processing Units).

However, processors such as MPUs are designed to operate in synchronization with a clock signal of a predetermined period and are therefore subject to overrunning when the period of this clock signal has become shorter than the predetermined period.

SU-A-1 798 919 discloses a device for monitoring clock signals. The device comprises a first D-flip-flop, a delay line and a second D-flip-flop configured in a ring; a delay line, a reset line and an output line. The device is reset by feeding a '1' to the reset line whereby the first D-flip-flop is set and the second D-flip-flop is reset. A sync signal is fed to the clock input of the first D-flip-flop. The pulse train which is to be monitored is fed to the clock input of the second D-flip-flop. A status signal is derived from the output of the first D-flip-flop.

The invention seeks to provide for a clock monitoring circuit having advantage over known such circuits.

According to the present invention there is provided a clock monitoring circuit comprising a first flip-flop circuit for latching and outputting an input signal when a given transition of a clock signal occurs between its two logic levels, a second flip-flop circuit for latching and outputting the output signal of the first flip-flop circuit when a given transition of the clock signal occurs between its two logic levels, delay means for delaying the output signal of the second flip-flop circuit by a time interval that is shorter than a predetermined period of the clock signal and for outputting the resultant signal as an input signal to the first flip-flop circuit, and a gate circuit for receiving the output signal of the first flip-flop circuit and the output signal of the second flip-flop circuit, and for outputting a signal of a first logic level when the period of the clock signal is equal to, or greater than, the predetermined time interval and for outputting a signal of a second logic level when the period of the clock signal is shorter than the predetermined time interval, and further comprising a third flip-flop circuit for latching the output signal of the gate circuit at a timing that is delayed from the latch of the second flip-flop circuit when a given transition of the clock signal occurs between its two logic levels.

The gate circuit is arranged such that it receives the output signals of the first and second flip-flop circuits and provides an output signal whose logic level depends on whether the period of the input clock signals is the predetermined period or not. A shortening of the period of the clock signal can thus be detected according to the logic level of the output signal of the clock monitoring circuit.

In a particular processing device to be described by way of example there is included the aforementioned clock monitoring circuit. When an abnormality in the clock signal is detected by the clock monitoring circuit, this abnormality is communicated to a control circuit that controls the operation of the processor, thereby halting the operation of the processor.

Advantageously the present invention can thus provide a clock monitoring circuit that can easily and accurately detect that the period of a clock signal has become shorter than a predetermined period.

The invention can therefore be used in a data processing device that is equipped with the above-described clock monitoring circuit and that can prevent overrunning of a processing circuit when the period of the clock signal has become shorter than the predetermined period.

Advantageously overrunning in the processing circuit due to abnormalities of the clock signal can then be stopped.

The following description and drawings disclose, by way of example, the invention which is characterised in the appended claims, whose terms determine the extent of the protection conferred hereby.

In the drawings:-
Fig. 1 is a block schematic diagram of a data processing device;
Fig. 2 is a circuit diagram illustrating the construction of the clock monitoring circuit shown in Fig. 1;
Fig. 3 is a timing chart illustrating the operation of the clock monitoring circuit illustrated in Fig. 2; and
Fig. 4 is a block diagram illustrating the construction of a data processing system.

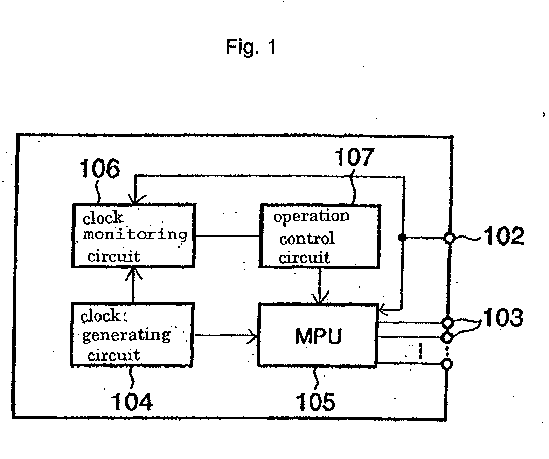

Referring now to Fig. 1, there is shown a data processing device which uses an embodiment of the present invention and which includes a reset input terminal 102, a plurality of data input/output terminals 103, a clock generating circuit 104, a Micro Processing Unit (MPU) 105 for data processing, a clock monitoring circuit 106, and an operation control circuit 107.

The reset input terminal 102 is connected to the MPU 105 and the clock monitoring circuit 106 and the data input/output terminal 103 is connected to the MPU 105. The MPU 105 is further connected to the clock generating circuit 104 and also the operation control circuit 107. The clock monitoring circuit 106 is also connected to the clock generating circuit 104 and to the operation control circuit 107.

The clock generating circuit 104 is provided with, for example, a crystal oscillator (not shown), and is arranged to generate a clock signal of a predetermined period T. A computer program for controlling processing, i.e. software or firmware, is installed in the MPU 105, and the MPU 105 executes appropriate processing steps in synchronization with the clock signal generated by the clock generating circuit 104.

It can be seen that the MPU 105 executes processing steps in accordance with the various types of data that are supplied from data input/output terminals 103, and outputs the resulting data from data input/output terminals 103. Accordingly, the data processor can communicate with external apparatus (not shown) by way of the data input/output terminals 103, and can execute various types of data processing steps in accordance with this communication.

When a reset signal is applied as input to the reset input terminal 102, the reset signal is applied to the MPU 105 and the clock monitoring circuit 106, whereby the MPU 105 and the clock monitoring circuit 106 are reset.

The clock monitoring circuit 106 monitors the period of the clock signal generated by the clock generating circuit 104. When the period of the clock signal becomes shorter than a predetermined reference time interval, the clock monitoring circuit 106 provides a clock abnormality signal for the operation control circuit 107. When the operation control circuit 107 receives the clock abnormality signal from clock monitoring circuit 106, it forcibly halts the processing performed by the MPU 105.

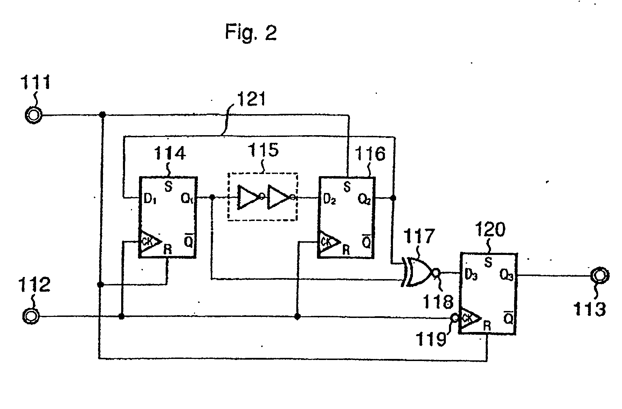

Referring now to Fig. 2, the clock monitoring circuit of this embodiment comprises a reset input terminal 111, a clock input terminal 112, a signal output terminal 113, a flip-flop (hereinafter abbreviated to FF) circuit 114, a signal delay circuit 115, a FF circuit 116, an exclusive-OR circuit 117, an inverter element 118, an inverter element 119, and a FF circuit 120.

The reset input terminal 111 is connected to the reset terminal of the FF circuit 114, the set terminal of the FF circuit 116, and the reset terminal of the FF circuit 120. The clock input terminal 112 is connected to the clock terminals of the FF circuit 114 and the FF circuit 116, and to the clock terminal of the FF circuit 120 by way of the inverter element 119. The signal input terminal of the FF circuit 114 and the signal output terminal of the FF circuit 116 are connected to each other through a feedback signal 121. In addition, the signal output terminal of the FF circuit 114 and the signal input terminal of the FF circuit 116 are connected by way of the signal delay circuit 115.

The signal output terminals of the FF circuit 114 and the FF circuit 116 are each connected to a respective signal input terminal of the exclusive-OR circuit 117. The signal output terminal of the exclusive-OR circuit 117 is connected to the signal input terminal of the FF circuit 120 by way of the inverter element 118. The signal output terminal of the FF circuit 120 is connected to the signal output terminal 113, and signal output terminal 113 is connected to the operation control circuit 107 (Fig. 1).

The FF circuit 114 is reset by the reset signal. The FF circuit 114 is arranged to receive an output signal Q₂ of the FF circuit 116 as input signal D₁. It then latches the input signal D₁ at the rising edge of an input clock signal CLK, and provides an output signal Q₁ as an input to the signal delay circuit 115.

The signal delay circuit 115 is made up of two inverter elements that are connected in series. The signal delay circuit 115 delays the output signal Q₁ from the FF circuit 114 by a predetermined time interval, and provides an input signal D₂ to the FF circuit 116. This delay time must be set shorter than the period of the normal clock signal and longer than the minimum period of the clock signal at which the MPU 105 can operate normally.

The FF circuit 116 is arranged to be set by the reset signal, to receive the input signal D₂, to latch the input signal D₂ at the rising edge of the received clock signal CLK, and to provide an output signal Q₂ as an output. The output signal Q₂ is supplied as an input signal D₁ to the FF circuit 114. The exclusive-OR circuit 117 exclusively ORs the output signal Q₁ from the FF circuit 114 with an output signal Q₂ from the FF circuit 116 and provides the resultant signal as an output. The inverter element 118 serves to invert the output signal of the exclusive-OR circuit 117 and provides the resultant signal as an input signal D₃ to the FF circuit 120.

The FF circuit 120 is arranged to be reset by the reset signal, to receive the input signal D₃ that is output from inverter 118, to latch the input signal D₃ at the rising edge of clock signal CLK that was inverted by inverter element 119, and to provide output signal Q₃ as an output. Output signal Q₃ of the FF circuit 120 is supplied to the operation control circuit 107 by way of the signal output terminal 113.

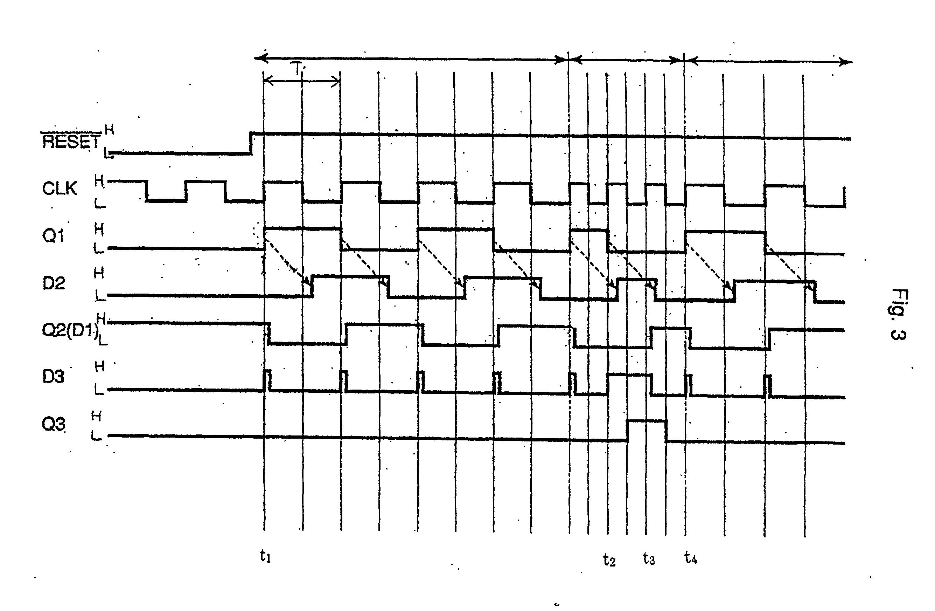

The operation of this embodiment will next be described with reference to Fig. 3. Upon receipt of a clock signal of a predetermined period T at the clock input terminal 112 at time t₁, output signal Q₂ (input signal D₁) of the FF circuit 116 is latched by the FF circuit 114 at the rising edge of the clock signal CLK and generated as the output signal Q₁.

The output signal Q₁ of the FF circuit 114 is delayed a predetermined time interval by the signal delay circuit 115. The FF circuit 116 receives the delayed signal, i.e., the input signal D₂ at the rising edge of the clock signal CLK, and provides the signal as the output signal Q₂.

If the period of the clock signal CLK is longer than the delay time of the signal delay circuit 115, the output signal Q₁ of the FF circuit 114 becomes a signal that is the inverted logic of the output signal Q₂ of the FF circuit 116. Also, the output signal Q₂ of the FF circuit 116 becomes a signal that is the inverted logic of the output signal Q₁ of the FF circuit 114. Accordingly, the output signal of the exclusive OR circuit 117 Is maintained at a low logical level.

If the operation of the FF circuit 114 and the operation of FF circuit 116 are not synchronized with complete accuracy, however, spike noise will occur in the output signal D₃ of the exclusive-OR circuit 117 even if the period of the clock signal CLK is longer than the delay time of the signal delay circuit 115. In a clock monitoring circuit embodying the invention, however, the FF circuit 120 receives, as its input signal D₃, the output signal of the exclusive-OR circuit 117 that has been inverted by the inverter element 118, and by matching the logic level of the output signal Q₃ with the logic level of the input signal D₃ at the rising edge of the clock signal CLK that is inverted by the inverter element 119. The spike noise that occurs in the output signal D₃ of the exclusive-OR circuit 117 due to the timing error between the FF circuit 114 and the FF circuit 116 is eliminated.

If the period of the clock signal CLK is shorter than the delay time of the signal delay circuit 115 at time t₂, the output signal Q₁ of the FF circuit 114 and the output signal Q₂ of the FF circuit 116 both go low between time t₂ and time t₃. The input signal D₃ of the FF circuit 120 accordingly goes high. The output signal Q₃ also goes high, and a clock abnormality signal is transmitted as output from the output terminal 113 to the operation control circuit 107. The operation control circuit 107 receives the clock abnormality signal and forcibly halts the operation of the MPU 105, thereby reliably preventing overrunning of the MPU 105.

When the period of the clock signal CLK returns to T at time t₄, the clock monitoring circuit 106 operates as previously described.

In the clock monitoring circuit 106 of the present embodiment, moreover, since the signal delay circuit 115 is constituted by logic circuits, the delay time of the signal delay circuit 115 does not vary in analog fashion, and since the clock monitoring circuit itself comprises by digital circuits, the clock monitoring circuit 106 is capable of stable operation.

The present invention is not limited to the above-described embodiment, and allows various modifications within the scope of the invention. Although the signal delay circuit 115 is formed by logic circuits and the clock monitoring circuit 106 is formed entirely by digital circuits in the above-described embodiment, an analog signal delay circuit comprising, for example, resistors and capacitors, or a signal delay circuit comprising a long wiring may also be used.

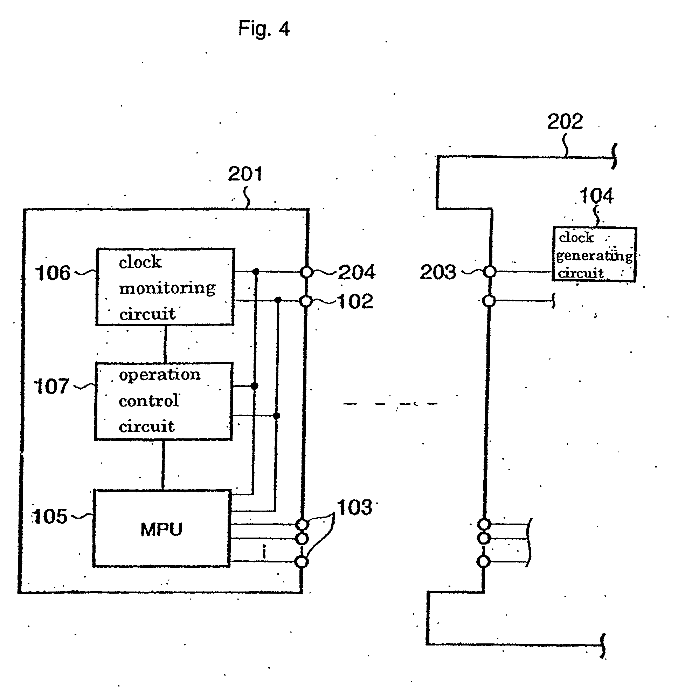

Furthermore, although an arrangement has been described in which a data processor incorporates a clock generating circuit, the data processing system 200 may be formed in a manner which includes a data processor 201 that does not incorporate a clock generating circuit, as shown in Fig. 4.

The data processing system 200 comprises parent device 202 which can be equipped with the data processor 201 as a subordinate device, and the parent device 202 comprises clock generating circuit 104 and clock output terminal 203. The data processor 201 can include a clock input terminal 204, and the clock input terminal 204 and the clock output terminal 203 are then connected when the data processor 201 includes the parent device 202.

The clock signal generated by the clock generating circuit 104 of the parent device 202 is supplied from the clock output terminal 203 to the clock input terminal 204 of the data processor 201, and each of the portions 105-107 of the data processing device 201 operate in synchronization with the clock signal.

As described previously, a clock signal is supplied from the parent device 202 to the data processor 201 in the data processing system 200. With such configuration, however, the data processor 201 can accept parent devices of a variety of standards, and a clock signal having a period that is shorter than the predetermined period may be supplied to the data processor 201. To avoid this, the data processing device 201 comprises the clock monitoring circuit 106 and the operation control circuit 107, and thereby prevents overrunning of the MPU 105.

Although the FF circuit 114 and the FF circuit 116 are designed to operate at the rising edge of the clock signal CLK, and the FF circuit 120 is designed to operate at the falling edge of the clock signal CLK in the clock monitoring circuit 106 of this embodiment, the FF circuit 114 and the FF circuit 116 may be designed to operate at the falling edge of clock signal CLK and the FF circuit 120 may be designed to operate at the rising edge of the clock signal CLK. In addition, inverted output signals $\overline{\text{Q}}$ may be used as the output signals of the FF circuit 114, the FF circuit 116, and the FF circuit 120, respectively, instead of the output signals Q₁, Q₂, and Q₃.

While preferred embodiments of the present invention have been described using specific terms, such description is for illustrative purposes only, and it is to be understood that changes and variations may be made without departing from the scope of the invention as defined by the appended claims.

## Claims

1. A clock monitoring circuit (106) comprising a first flip-flop circuit (116) for latching and outputting an input signal when a given transition of a clock signal occurs between its two logic levels, a second flip-flop circuit (114) for latching and outputting the output signal of the first flip-flop circuit (116) when a given transition of the clock signal occurs between its two logic levels, delay means (115) for delaying the output signal of the second flip-flop circuit (114) by a time interval that is shorter than a predetermined period of the clock signal and for outputting the resultant signal as an input signal to the first flip-flop circuit (116), and a gate circuit (117) for receiving the output signal of the first flip-flop circuit (116) and the output signal of the second flip-flop circuit (114), and for outputting a signal of a first logic level when the period of the clock signal is equal to, or greater than, the predetermined time interval and for outputting a signal of a second logic level when the period of the clock signal is shorter than the predetermined time interval, and further comprising a third flip-flop circuit (120) for latching the output signal of the gate circuit (117) at a timing that is delayed from the latch of the second flip-flop circuit (114) when a given transition of the clock signal occurs between its two logic levels.

2. A circuit as claimed in claim 1, wherein the positive output terminal of the first flip-flop circuit (116) is connected to the input terminal of the second flip-flop circuit (114), and the input terminal of the delay means (115) is connected to the positive output terminal of the second flip-flop circuit (114), and wherein the gate circuit (117) comprises an exclusive-OR circuit that exclusively ORs the output signal of the positive output terminal of the first flip-flop (116) circuit with the output signal of the positive output terminal of the second flip-flop circuit (114).

3. A circuit as claimed in claim 1 or 2, wherein the delay means (115) comprise logic circuit means.

4. A circuit as claimed in claim 3, wherein the delay means (115) comprises a plurality of inverter elements connected in series.

5. A circuit as claimed in claim 2, further comprising a third flip-flop circuit for latching and outputting either the output signal of the exclusive-OR circuit or the inverted signal of the output signal of the exclusive-OR circuit, at a timing that is delayed from the latch of the second flip-flop circuit when a given transition of the clock signal occurs between its two logical levels.

## Patentansprüche

1. Taktüberwachungsschaltung (106) mit einer ersten Flipflopschaltung (116) zum Zwischenspeichern und Ausgeben eines Eingangssignals, wenn ein vorgegebener Übergang eines Taktsignals zwischen seinen beiden Logikpegeln auftritt, einer zweiten Flipflopschaltung (114) zum Zwischenspeichern und Ausgeben des Ausgangssignals der ersten Flipflopschaltung (116), wenn ein vorgegebener Übergang des Taktsignals zwischen seinen beiden Logikpegeln auftritt, einer Verzögerungseinrichtung (115) zum Verzögern des Ausgangssignals der zweiten Flipflopschaltung (114) um ein Zeitintervall, das kürzer als eine vorbestimmte Periode des Taktsignals ist, und zum Ausgeben des resultierenden Signals als Eingangssignal zur ersten Flipflopschaltung (116), und einer Gatterschaltung (117) zum Empfangen des Ausgangssignals der ersten Flipflopschaltung (116) und des Ausgangssignals der zweiten Flipflopschaltung (114) und zum Ausgeben eines Signals mit einem ersten Logikpegel, wenn die Periode des Taktsignals gleich oder größer als das vorbestimmte Zeitintervall ist, und zum Ausgeben eines Signals mit einem zweiten Logikpegel, wenn die Periode des Taktsignals kürzer als das vorbestimmte Zeitintervall ist, und ferner mit einer dritten Flipflopschaltung (120) zum Zwischenspeichern des Ausgangssignals der Gatterschaltung (117) bei einer Taktung, die gegenüber der Zwischenspeicherung der zweiten Flipflopschaltung (114) verzögert ist, wenn ein vorgegebener Übergang des Taktsignals zwischen seinen beiden Logikpegeln auftritt.

2. Schaltung nach Anspruch 1, wobei der positive Ausgangsanschluß der ersten Flipflopschaltung (116) mit dem Eingangsanschluß der zweiten Flipflopschaltung (114) verbunden ist und der Eingangsanschluß der Verzögerungseinrichtung (115) mit dem positiven Ausgangsanschluß der zweiten Flipflopschaltung (114) verbunden ist und wobei die Gatterschaltung (117) eine Exklusiv-ODER-Schaltung aufweist, die eine Exklusiv-ODER-Verknüpfung des Ausgangssignals des positiven Ausgangsanschlusses der ersten Flipflopschaltung (116) mit dem Ausgangssignal des positiven Ausgangsanschlusses der zweiten Flipflopschaltung (114) vornimmt.

3. Schaltung nach Anspruch 1 oder 2, wobei die Verzögerungseinrichtung (115) eine Logikschaltungseinrichtung aufweist.

4. Schaltung nach Anspruch 3, wobei die Verzögerungseinrichtung (115) mehrere in Reihe geschaltete Inverterelemente aufweist.

5. Schaltung nach Anspruch 2, ferner mit einer dritten Flipflopschaltung zum Zwischenspeichern und Ausgeben des Ausgangssignals der Exklusiv-ODER-Schaltung oder des invertierten Signals des Ausgangssignals der Exklusiv-ODER-Schaltung bei einer Taktung, die gegenüber der Zwischenspeicherung der zweiten Flipflopschaltung verzögert ist, wenn ein vorgegebener Übergang des Taktsignals zwischen seinen beiden Logikpegeln auftritt.

## Revendications

1. Circuit de surveillance d'horloge (106) comprenant un premier circuit de bascule (116) pour verrouiller et produire un signal d'entrée quand une transition donnée d'un signal d'horloge se produit entre ses deux niveaux logiques, un second circuit de bascule (114) pour verrouiller et produire le signal de sortie du premier circuit de bascule (116) quand une transition donnée du signal d'horloge se produit entre ses deux niveaux logiques, un moyen de retard (115) pour retarder le signal de sortie du second circuit de bascule (114) d'un intervalle de temps qui est plus court qu'une période prédéterminée du signal d'horloge et pour produire le signal résultant comme signal d'entrée au premier circuit de bascule (116), et un circuit porte (117) pour recevoir le signal de sortie du premier circuit de bascule (116) et le signal de sortie du second circuit de bascule (114), et pour produire un signal d'un premier niveau logique quand la période du signal d'horloge est égale, ou supérieure, à l'intervalle de temps prédéterminé et pour produire un signal d'un second niveau logique quand la période du signal d'horloge est plus courte que l'intervalle de temps prédéterminé, et comprenant par ailleurs un troisième circuit de bascule (120) pour verrouiller le signal de sortie du circuit porte (117) à une temporisation retardée par rapport au verrouillage du second circuit de bascule (114) quand une transition donnée du signal d'horloge se produit entre ses deux niveaux logiques.

2. Circuit selon la revendication 1, dans lequel la borne positive de sortie du premier circuit de bascule (116) est connectée à la borne d'entrée du second circuit de bascule (114), et la borne d'entrée du moyen de retard (115) est connectée à la borne positive de sortie du second circuit de bascule (114), et dans lequel le circuit porte (117) comprend un circuit OU exclusif qui applique une fonction OU exclusif au signal de sortie de la borne positive de sortie du premier circuit de bascule (116) avec le signal de sortie de la borne positive de sortie du second circuit de bascule (114).

3. Circuit selon la revendication 1 ou 2, dans lequel le moyen de retard (115) comprend un moyen de circuit logique.

4. Circuit selon la revendication 3, où le moyen de retard (115) comprend une pluralité d'éléments inverseurs connectés en série.

5. Circuit selon la revendication 2, comprenant par ailleurs un troisième circuit de bascule pour verrouiller et produire, soit le signal de sortie OU exclusif du circuit, soit le signal inversé du signal de sortie du circuit OU exclusif, après une temporisation correspondant au retard du verrouillage du second circuit de bascule quand une transition donnée du signal d'horloge se produit entre ses deux niveaux logiques.
